# EUROPEAN PATENT APPLICATION

(11) **EP 4 478 845 A1**
(43) Date of publication of application: **18.12.2024**
(21) Application number: 23179339.9
(22) Date of filing: 14.06.2023
(51) Int. Cl.: H05K 3/42, H05K 3/00, H05K 3/46

(54) **COMPONENT CARRIER WITH CONTINUOUSLY EXTENDING VERTICAL CONNECTION STRUCTURE, AND MANUFACTURING METHOD**

(71) Applicant: AT & S Austria Technologie & Systemtechnik Aktiengesellschaft, 8700 Leoben-Hinterberg (AT)
(72) Inventor: Leitgeb, Markus, 8793 Trofaiach (AT); Oggioni, Stefano Sergio, 8700 Leoben (AT); Steinberger, Anke, 8792 St. Peter (AT)
(74) Representative: Dilg, Haeusler, Schindelmann Patentanwaltsgesellschaft mbH

(57) **Abstract**

There is described a component carrier (100), comprising a stack (101) having at least one electrically conductive layer structure (104) and a plurality of electrically insulating layer structures (102, 112).

The at least one electrically conductive layer structure (104) comprises a vertical connection structure (150) continuously extending vertically through at least two of the plurality of electrically insulating layer structures (102, 112).

## Description

### Field of the Invention

The invention relates to a component carrier with a stack comprising at least one electrically conductive layer structure and a plurality of electrically insulating layer structures, wherein a vertical connection structure extends continuously through at least two of the electrically insulating layer structures. Further, the invention relates to a method of manufacturing said component carrier.

Accordingly, the invention may relate to the technical field of component carriers, such as printed circuit boards or IC substrates.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, manufacturing reliable (electrical) interconnections (such as vias) in a component carrier may be a challenge. Conventionally, through-holes extending through a dielectric layer are formed by laser drilling. Afterwards, the through-holes are filled by electrically conductive material, normally copper, using a plating process. While in some applications the whole through-holes is filled, in other applications only sidewalls are covered with electrically conductive material (plated through-holes).

However, the conventional approaches may have some drawbacks. The laser drilled vias comprise a tapering from (V-shaped) as a consequence of the laser drilling process. In order to avoid that the width of vias becomes smaller and smaller along the thickness direction of the component carrier, vertical through-connections are realized by a plurality of layer structures (each comprising a blind via), wherein blind-vias of the different layers are stacked one above the other.

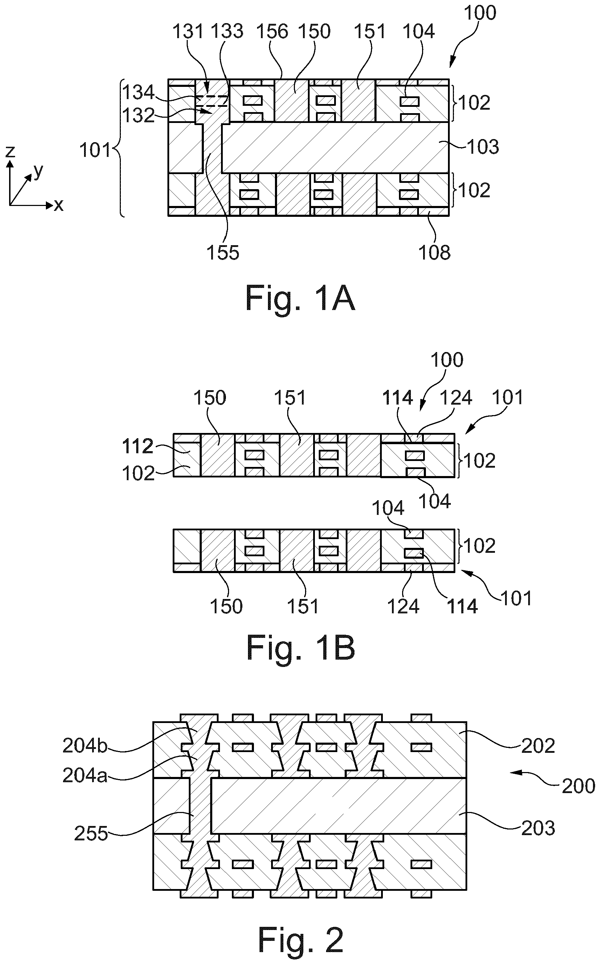

**Figure 2** shows an example of a conventional circuit board 200 which comprises a stack with a core 203 and a plurality of insulating layers 202 stacked on top of each other above and below the core 203. A through-via 255 extends through the core 203 and is electrically connected at the top end and at the bottom end to respective vertical connections. Hereby, each vertical connection comprises a plurality of different blind vias 204a, 204b stacked on top of each other. This structure reflects a manufacturing process, wherein the stack is build-up layer by layer, wherein for each insulating layer 202, holes are drilled by a laser, then the holes are filled with copper, and only then the next layer is added.

In other words, a conventional vertical through connection in a layer stack is manufactured by a plurality of stacked (and tapering) blind vias, which extend vertically in a discontinuous manner. This process requires dielectric openings and electrical interconnection layers. In order to avoid a mechanical/electrical damage, landing pads (formed from an electrical interconnection layer) are applied and need to be large. Nevertheless, the conventional through-connections may have a negative impact on signal integrity. Additionally, they may be cumbersome to manufacture and may consume a lot of space.

### Summary of the Invention

There may be a need to provide a component carrier with reliable and robust electrical interconnections.

A component carrier and a manufacturing method are described.

According to an aspect of the invention, there is described a component carrier, having a (layer) stack comprising at least one electrically conductive layer structure (e.g. a metal layer/trace/via) and a plurality of electrically insulating layer structures (e.g. a reinforced resin).

The at least one electrically conductive layer structure comprises a vertical connection structure continuously extending vertically (in particular with substantially continuous vertical sidewalls) through at least two (in particular a plurality) of the plurality of electrically insulating layer structures.

According to a further aspect of the invention, there is described a method of manufacturing a component carrier, wherein the method comprises:
i) providing/forming a stack comprising at least one electrically conductive layer structure and a plurality of electrically insulating layer structures; and
ii) forming the at least one electrically conductive layer structure with a vertical connection structure continuously extending vertically through at least two of said plurality of electrically insulating layer structures.

In the present context, the term "vertical connection structure" may refer to an electrically conductive structure that extends in the vertical direction (at least partially) through a component carrier stack. In particular, the vertical connection structure may be configured to electrically connect two entities, e.g. an electronic component and a layer structure/trace/pad. In comparison to prior art stacked blind vias (see above), the vertical connection structure may be configured as a single via, e.g. comprising continuous sidewalls. Preferably, the vertical connection structure is homogenously formed by one metal, e.g. copper. In an example, the vertical connection structure might be formed/filled by conductive paste or anisotropic conductive film, which may comprise for example at least one of micro and/or nano metal particles, adhesive material, another solvent. Alternatively, the vertical connection structure may be formed by a metalized side wall in a hole, which is then filled with electrically insulating material, e.g. plug paste. In a further example, the (bulk) metal material may be coated (e.g. by graphene). In an example, the vertical connection structure may be formed as a (copper) pillar. In an example, the width of the vertical connection structure is constant in the vertical direction (along its extension). The continuous extension may be through at least two (in particular a plurality) of electrically insulating layer structures. In an embodiment, the vertical connection structure is formed by plating, in particular by plating in the first place and by embedding in insulating material in the second place.

In the present context, the term "electrically conductive layer structure" may refer to any layer and/or structure that is electrically conductive (e.g. metal) and suitable to be arranged in a component carrier stack. In an example, an electrically conductive layer may be formed (e.g. plating, laminating, printing etc.) and then patterned. In another example, a patterned foil may be applied. The electrically conductive layer structure may comprise a layer, a trace, a pad, a terminal, a via, a vertical connection structure, etc.; in particular a plurality of these. Several electrically conductive layer structures may be stacked (in particular alternatingly with electrically insulating layer structures) in a component carrier layer stack. For example, in Figure 1A, there are shown three layers of electrically conductive layer structure metal traces. In between, there are arranged vertical connection structures, that may also be seen as part/portion of the electrically conductive layer structures.

In the present context, the term "electrically insulating layer structure" may refer to any layer and/or structure that is electrically insulating (e.g. resin, glass, ceramic) and suitable to be arranged in a component carrier stack. Electrically insulating material may be provided during the layer build-up process, e.g. by lamination or coating. Per electrically conductive layer structure, an electrically insulating layer structure may be formed. For example, in Figure 1A, several layers of electrically insulating layer structures can be seen, two of them between (regarding stack thickness (z) direction) respective electrically conductive layer structures. Thus, the term "extending through at least two electrically insulating layer structures" may refer to the circumstance that a vertical connection structure extends through at least two of said electrically insulating layer structures as formed during the manufacture process. These electrically insulating layer structures may be delimited from each other for example by an electrically conductive layer structure (in particular metal traces) formed in between the two electrically insulating layer structures. The electrically insulating layer structure may (be a resin and) comprise a filler material, e.g. fiber or spheres. There may be several possible functions of fillers (e.g. control CTE, thermal conductivity, dielectric property, DK (relative permittivity εr) and reinforcement). A core layer structure may also comprise the electrically insulating layer structure (in particular with an additional fabric for increased reinforcement/mechanical stability).

In the present context, the term "continuous extension" may be seen in particular as a structural feature of the vertical connection structure, according to which the vertical connection structure extends in a continuous manner, without abrupt changes (discontinuous; in other words: (dimensional) discontinuities)), such as an abrupt change of the width along the vertical direction. This may be in contrast to prior art examples (see above), wherein a vertical connection is formed by a plurality of stacked blind vias, so that there is an abrupt change of the width at each via interface. Due to the layer-wise manufacture process, the conventional (laser) vias extend only through exactly one electrically insulating layer, respectively. The described vertical connection structure, however, may extend in the continuous manner through two or more electrically insulating layer structures. Preferably, the vertical connection structure may comprise continuously extending sidewalls.

In other word, an extension of the basic form, for example the diameter, of the vertical connection structure may remain constant over the height in stack thickness direction (vertical direction) and there may be no inclination between the parallel shifted extremities of the vertical connection structure, compared to cylindrical or cuboid geometrical forms. In the context of the present document, the term "component carrier" may particularly denote any support structure which is capable of accommodating one or more components thereon and/or therein for providing mechanical support and/or electrical connectivity and/or thermal conductivity. In other words, a component carrier may be configured as a mechanical and/or electronic and/or thermal carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers. In an example, the component carrier comprise at least one electrically conductive layer and at least one electrically insulating layer.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In an embodiment, the component carrier "stack" comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high density product. The stacking direction (height/thickness) may be arranged in the vertical direction z. Further, the stacking direction may be perpendicular to the two directions of main extension (along x and y) of the (plate-shaped) component carrier.

In this context, the term "layer structure" may in particular refer to a continuous or discontinuous layer (or separated islands within the same plane) of electrically conductive or electrically insulating material. A plurality of such layers, parallel stacked one upon the other, may form the stack in the vertical direction.

According to an exemplary embodiment, the invention may be based on the idea that a component carrier with reliable and robust electrical interconnections may be provided, when a vertical connection structure continuously extends vertically through at least two electrically insulating layer structures of a component carrier layer stack.

Conventionally (see Figure 2), vertical connections may be realized by a plurality of stacked laser blind-vias. However, it has been found by the inventors that the robustness and reliability of a vertical connection structure may be significantly improved, when a continuous vertical extension is provided.

In this manner, mis-alignment of stacked blind-vias may be avoided, in particular the need for large landing pads may be overcome. The signal integrity may be improved, while smaller vias may be possible that do not require a laser drilling manufacturing process. By forming smaller vias, the vertical connection structure may require less space in the component carrier, thereby improving miniaturization. The described advantageous component carrier may be manufactured using established component carrier techniques, so that a straightforward implementation into existing production lines may be enabled.

Further advantages may include a landless interconnection, a via formation in one step, an elimination of the drilling process, a tested z-connection, an enablement of smaller feature like different bump pitch, improved electrical properties (e.g. less signal loss, higher signal integrity, less electrical field effects), a higher layer-to-layer accuracy, and a better alignment.

### Exemplary Embodiments

According to an embodiment, the at least one electrically conductive layer structure comprises at least one further vertical connection structure continuously extending vertically through at least two of said plurality of electrically conductive layer structures. This may provide the advantage that two or more vertical connection structures can establish complex (but very design-flexible) electrical connections to and/or within the component carrier.

In an example, the vertical connection structure and the further vertical connection structure are arranged adjacent to each other, in particular oriented in parallel along the vertical direction. In another example, the vertical connection structure and the further vertical connection structure are arranged on top of each other (in the vertical direction), either directly on top of each other or offset. The vertical connection structure and the further vertical connection structure may be connected or disconnected to each other. In a further example, the vertical connection structure and the further vertical connection structure may have a similar, in particular identical, length in vertical direction. Additionally, or alternatively, the vertical connection structure and the further vertical connection structure may have a different length in vertical direction.

In a further embodiment, the vertical connection structure and the further vertical connection structure are electrically connected with each other, in particular, by (a part of) the electrically conductive layer structure. In a further embodiment, the vertical connection structure and the further vertical connection structure are electrically connected with each other free of an electrically conductive layer structure (in between). By electrically connecting two or more of the vertical connection structure, an especially efficient electrical connection may be established, for example in form of a network structure (see specification below). For example, two or more of the vertical connection structure and one or more of the further vertical connection structure are electrically connected. The two or more vertical connection structures may be similar or different in shape/form. Further, the vertical connection structures may have a similar or different width (diameter). The shape of the vertical connection structure is not limited, and may be e.g. circular, rectangular, or polygonal.

In a further embodiment, the vertical connection structure and the further vertical connection structure comprise a different width or a similar width, in particular identical width. Thereby, the design-flexibility may be enhanced. Even though the width may be different, each vertical through connection may continuously extends through two or more electrically insulating layer structures.

In an exemplary embodiment, the vertical connection structure comprises a diameter (width) in the range 1 to 100 µm (in particular 5 µm or smaller). In an exemplary embodiment, the further vertical connection structure comprises a diameter (width) in the range 1 to 100 µm (in particular 10 µm or smaller). Preferably, said diameter can be 10 µm or smaller.

In a further embodiment, the vertical connection structure and the further vertical connection structure are offset one to each other along the stack thickness direction (the stacking direction, along the vertical axis z) or perpendicular thereto. Accordingly, offset vertical connection structures may enable an efficient and reliable (yet design-flexible) electrical connection. For example, the vertical connection structures may be electrically connected by a (vertical or horizontal) metal trace. In an example, the offset can be in the range between 2 µm (or even close to 0 µm) and 50 µm.

In an example, an offset between the vertical connection structure and the further vertical connection structure and a further offset between the same vertical connection structure and another vertical connection structure or another further vertical connection structure may be similar, in particular identical. Additionally and/or alternatively, an offset between the vertical connection structure and the further vertical connection structure and a further offset between the same vertical connection structure and another vertical connection structure or another further vertical connection structure may be different.

In a further embodiment, the vertical connection structure, the further vertical connection structure, and at least one further element (e.g. a metal trace) of the at least one electrically conductive layer structure form an electrically conductive network structure, in particular a bifurcated electrically conductive network structure. Thereby, the advantages of the continuously extending vertical connection structures may be enlarged to a complex electrical connection structure, in particular directly during the manufacture process.

In the present context, the term "further element" may in particular refer to an electrically conductive structure suitable to electrically connect two or more, in particular three or more, vertical connection structures. In an example, the further element is configured as e.g. a metal trace, metal pad, or metal foil that connects the vertical connection structures. The further element may be part of the electrically conductive layer structure. In a preferred example, the further element may be oriented in the component carrier in such a way, that between the vertical connection structure and the further element an angle between 80° and 100°, in particular 90°, and that between the further vertical connection structure and the further element an angle between 80° and 100°, in particular 90°, is created.

In an embodiment, the thickness range for a via structure can be 2 to 50 µm, in particular 15 µm or smaller, in particular 10 µm or smaller. For metal traces, the height might be even smaller, e.g. 20 µm or smaller, in particular 10 µm or smaller, more in particular 5 µm or smaller.

In a further embodiment, the bifurcated electrically conductive network structure comprises at least two extremities at one side and one extremity at a further, opposed, side. For example, a vertical connection structure is connected (via the further element, in particular horizontally) to the further vertical connection structure, one of the vertical connection structures being shorter (in the vertical direction) than the other. Thereby, a h-shaped ( 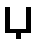 - or Y-shaped, preferably with 90° angles) vertical connection structure may be formed as the bifurcated network. Using such a design, an electrical connection at the lower part of the h-shape to two electric connectors (e.g. pads, terminal, solder bumps) of an electronic component may be established.

In a further embodiment, the bifurcated electrically conductive network structure comprises at least three extremities at one side and one (or two) extremities at a further, opposed, side. For example, a vertical connection structure is connected (via the further element, in particular horizontally) to two of the further vertical connection structures, wherein the further vertical connection structures are shorter (in the vertical direction) than the vertical connection structure. Thereby, a trident-shaped (compare Greek letter ψ (psi) or Cyrillic letter 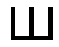 (sch)) vertical connection structure may be formed as the bifurcated network structure. Using such a design, an electrical connection at the upper part of the trident-shape to two or three electric connectors (e.g. pads, terminal, solder bumps) of an electronic component may be established.

In a further embodiment, at least two of the vertical connection structure, the further vertical connection structure, and the at least one further element are connected, in particular within the bifurcated electrically conductive network structure, in a rectangular form (in particular comprises angles of (approximately 90°). This structural feature may reflect a manufacture step of forming the further element from (patterned) electrically conductive layers (horizontally) and the vertical connections structures by plating (vertically). Thus, the rectangular form may result from a horizonal and a vertical electrically conductive material formation. Hence, the electrically conductive network structure may be directly formed in an efficient manner during the manufacture process.

In a further embodiment, the vertical connection structure is formed on or above a core layer structure. A core layer structure (e.g. a fully cured (reinforced) resin, a glass substrate or a metal substrate) may provide a certain stability and robustness to the component carrier and the build-up process, thereby avoiding warpage. Layer build-up (of the stack) can be done directly on the upper and/or lower main surface of the core layer structure.

In a further embodiment, the vertical connection structure is electrically connected with a vertical through-connection, in particular having substantially continuous vertical sidewalls, extending vertically through the core layer structure (see e.g. Figure 1A). In this example, one or more electrically conductive through-connections are formed through the core layer structure, which can be directly connected to the vertical connection structures. Thereby, an efficient and robust (through) connection within the component carrier may be provided.

The vertical through-connection may continuously extend through the core, in particular comprise continuous sidewalls. The vertical through-connection may be configured as a (completely) filled via, a via with conductive sidewalls (plated through-hole), or may be filled with electrically insulating material (surrounded by electrically conductive sidewalls). In an example, the vertical through-connection comprises a larger or smaller width than the vertical connection structure. In another example the vertical through-connection comprises a similar width as the vertical connection structure.

In a further embodiment, the vertical connection structure is formed in a coreless stack (see e.g. Figure 1B). Such a component carrier may be formed based on a temporary carrier to provide sufficient stability during the manufacture process. A coreless component carrier may be thinner and more flexible in comparison to a component carrier with a core.

In a further embodiment, a free end of the vertical connection structure is exposed with respect to one of the stack surfaces. This may provide the advantage that a portion of the vertical connection structure is exposed to direct electrical connection, e.g. to an electronic component.

In a further embodiment, the free end is connected with a further electrically conductive layer structure (e.g. arranged below the vertical connection structure). Thereby, a large vertical connection (in particular through each layer stack) may be enabled in an efficient manner.

In a further embodiment, the vertical connection structure is connected to a horizontal (metal) trace of the at least one electrically conductive layer structure. Thereby, electric interconnections with the stack may be formed in an easy but reliable manner, especially during the manufacture process. The connected vertical connection structures (e.g. pillars) may be coaxial or off-set.

In a further embodiment, said (metal) trace is arranged at a vertical level in between vertical levels of opposing vertical ends of said vertical connection structure and/or said further vertical connection structure. For example, a first vertical connection structure may be formed in the first place, an electrically conductive layer structure (that comprises the trace) may be formed in the second place, and then, a second vertical connection structure may be formed on top in the third place, so that the horizontal trace may act as an interconnector. When the vertical connection structures are offset, complex (bifurcated) shapes may be provided.

In a further embodiment, the vertical connection structure is composed of at least two stacked sub-portions with an interface in between, in particular wherein said interface, in particular a surface, is at the same vertical level as an interface between two adjacent electrically insulating layer structures. While the above described horizontal trace is an electrically conductive element on its own, the interface may be rather seen as a surface between the vertical connection structures. Thereby, a smooth interface, e.g. without changing the width, may be formed.

In a further embodiment, a lateral misalignment between said continuously vertically extending (preferably, extending perpendicularly with the respect to the center line) sub-portions is so that the center lines of each sub-portion are positioned inside of a virtual circle of a diameter in a range from 2 µm to 10 µm, in particular not more than 5 µm.

In the context of this document, the term "center line" may describe an imaginary line extending through the center of a basis area/region, for example a circle, of one extremity of the vertical connection structure and the center of another basis area of another opposed extremity of the same vertical connection structure.

In a further embodiment, lateral steps between the adjacent sub-portions of the continuously vertically extending connection structure are below 2 µm, in particular below 1 µm. Said lateral steps may reflect a lateral misalignment during the manufacture process. Nevertheless, since the lateral steps are so small, the drawbacks of the misalignment may be effectively overcome.

Thus, a high quality vertical connection may be provided with very small misalignment, thereby eventually improving the performance.

In a further embodiment, the vertical connection structure is made of a homogeneous material, in particular plated metal, more particular plated copper. The (signal) integrity and/or the stability of the vertical connection structure may be enhanced by a homogenous material. Further, the manufacture may be straightforward and efficient. For example, the vertical connection structure may be configured as a continuous copper pillar.

In a further embodiment, the vertical connection structure is made of a heterogeneous material (for example conductive paste and/or anisotropic conductive film). With this material, it might have simple manufacturing procedure with cost efficiency as it may just need a roller coating or lamination machine to form it directly. Especially for some situations, such as when the core is inorganic material, the conventional plating process might not be able to form the structure in a desired manner, so that said material may be preferable.

In a further embodiment, one or more metal structures (in particular metal traces, e.g. from an electrically conductive layer structure) are located (in the vertical direction) below and/or above the further element of the network structure. Additionally, or alternatively, one or more metal structures (in particular metal traces, e.g. from a third electrically conductive layer structure) are located (horizontally) between the vertical connection structure and a further vertical connection structure of the bifurcated electrically conductive network structure.

A main surface of said metal structures may face a side of the vertical connection structure and/or the bifurcated electrically conductive network structure. In this context, the term "main surface" may refer to an outer (exposed) surface along (in parallel) to a direction of main extension, e.g. along the x,y-plane, and perpendicular to a stack thickness direction (along z).

In a further embodiment, the bifurcated structure is bifurcated along one of the axes, but it can for example be also in the orthogonal direction. In a further embodiment, the bifurcated structure comprises two connections in a form of a cross. In a further embodiment, the bifurcated structure comprises six or more connections (e.g. star-form).

In a further embodiment a section/portion inside the component carrier (layer stack) may be free from tapered shaped (standard laser vias) electrically conductive connections. And thus comprise potentially a higher (signal) integrity.

In a further embodiment component carrier comprises at least one (electronic; active or passive) component. Said component may be mounted on and/or embedded in the component carrier. Further, the component may be electrically connected to at least one vertical connection structure. In particular, one or more components are connected to the free ends of the bifurcated electrically conductive network structure. Hereby, the electric connections of the component (and/or the free ends of the network structure) may comprise different distances between each other (e.g. different bump pitch). Thus, an efficient and reliable electric connection, in particular complex and with high design flexibility, may be provided.

In a further embodiment, at least two, in particular a plurality of, electrically insulating layer structures are in direct contact with at least two, in particular four, side wall (portions) of the vertical connection structure and/or the further vertical connection structure. This structure(s) may reflect a manufacturing process and may ensure high product integrity.

In a further embodiment, at least a portion of the sidewall of the vertical connection structure and/or the further vertical connection structure has/have a surface roughness, in particular a surface roughness parameter Ra, smaller than 10 µm (in particular smaller than 5 µm). In a specific example, Ra may be smaller than 800 nm, for example in the range 500 nm to 800 nm (for example for high performance computing). This may bring the advantage of that the vertical connection structure and/or the further vertical connection structure is/are configured of transmitting electromagnetic signals, in particular signals for HF applications.

In a further embodiment, the method further comprising: wherein forming the vertical connection structure further comprises: plating the vertical connection structure, in particular on and/or in a core layer structure or a temporary carrier. Thereby, established component carrier manufacture techniques may be directly applied. Instead of forming a via by filling a hole, the described vertical connection structure may be formed by plating onto a support structure such as a core or a carrier.

In a further embodiment, the method further comprising: embedding, in particular by laminating, the at least one electrically conductive layer structure, in particular with the vertical connection structure at least partially in at least one of the electrically insulating layer structures, in particular wherein the embedding is done after forming the vertical connection structure by plating. This build-up process may be opposite to conventional processes (wherein holes are formed in the insulating material, which are then filled by metal) and enables continuous extending in the vertical direction, in particular with a high design flexibility regarding complex angular/network interconnections.

In a further embodiment, the vertical connection structure protrudes at least partially into the core layer structure (see e.g. Figure 1A). Such a structural feature can reflect a manufacture process including a two-step process of removing material of the core layer structure and filling the opening with electrically conductive material (e.g. drilling and (copper) plating). Thereby, stability/robustness may be enhanced.

In an embodiment, the component carrier is configured as one of the group consisting of a printed circuit board, a substrate (in particular an IC substrate), and an interposer.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low Dk materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

### Brief Description of the Drawings

The aspects defined above and further aspects of the invention are apparent from the examples of embodiment to be described hereinafter and are explained with reference to these examples of embodiment.
Figures 1A and 1B respectively show a component carrier according to an exemplary embodiment of the invention.
Figure 2 shows a conventional circuit board.
Figures 3A to 3K show a first method of manufacturing a component carrier according to an exemplary embodiment of the invention.
Figures 4A to 4K show a second method of manufacturing a component carrier according to an exemplary embodiment of the invention.
Figures 5A to 5K show a third method of manufacturing a component carrier according to an exemplary embodiment of the invention.

### Detailed Description of the Drawings

**Figures 1A and 1B** respectively show a component carrier 100 according to an exemplary embodiment of the invention.

Figure 1A: the component carrier 100 comprises a stack 101 having a plurality of electrically conductive layer structures 104 and a plurality of electrically insulating layer structures 102. The at least one electrically conductive layer structure 104 comprises a plurality of vertical connection structures 150, 151 that continuously extend vertically through a plurality of the electrically insulating layer structures 102 and comprise (substantially) continuous sidewalls, respectively. The vertical connection structures 150 are formed as pillars and are made of a homogeneous material, for example a plated metal such as copper.

The stack 101 comprises a core layer structure 103 with a vertical through-connection 155, which is electrically connected at the top and the bottom side to a respective vertical connection structure 150. Hereby, the vertical connection structures 150 respectively comprise a larger (or smaller) width than the vertical through connection 155. Above and below the core layer structure 103, there are arranged (symmetrically) the plurality of electrically insulating layer structures 102, through which the vertical connection structures 150 extend up to a respective layer stack/component carrier main surface, also through an outer layer 108, e.g. a surface finish or a solder resist. At the main surface, the vertical connection structures 150 respectively terminate with an exposed free end 156 (with respect to one of the stack surfaces). The exposed free end 156 is flush with the main surface of the component carrier. Additionally and/or alternatively, the exposed free end 156 may protrude out and/or be indented in the main surface of the component carrier (not shown).

Further electrically conductive layer structures 104 are arranged in between (in particular embedded) the electrically insulating layer structures 102 and are illustrated in Figure 1A as metal pads between the vertical connection structures 150. Alternatively, there may be some portions inside the component carrier 100, which are free from further electrically conductive layer structures 104 arranged in between the electrically insulating layer structures 102 (not shown). The electrically conductive layer structure 104 further comprises a further vertical connection structure 151 continuously extending vertically through a plurality of said plurality of electrically conductive layer structures 102, in this example the vertical connection structure 150 and the further vertical connection structure 151 are oriented in parallel and (offset one to each other along the stack thickness direction z). In this example, the terms vertical connection structure 150 and the further vertical connection structure 151 can be exchangeable.

The vertical connection structure 150 is connected to a horizontal trace 134 of the electrically conductive layer structure 104 (which trace 134 extends in the horizontal direction in between the vertical connection structures 150 and forms part of a discontinuous electrically conductive layer structure. Said trace 134 is arranged at a vertical level in between vertical levels of opposing sub-portions 131, 132 of the vertical connection structure 150.

Additionally or alternatively, the vertical connection structure 150 is composed of the at least two stacked sub-portions 131, 132 with an interface 133 in between, wherein said interface 133, being an interface surface, is at the same vertical level as an interface between two adjacent electrically insulating layer structures 102. In the present example, the trace 134 and the interface 133 can be arranged at a similar location.

A lateral misalignment between said continuously vertically extending sub-portions 131, 132 is so that the center lines of each sub-portion 131, 132 are positioned inside of a virtual circle of a diameter not more than 5 µm. Further, lateral steps between the adjacent sub-portions 131, 132 of the continuously vertically extending connection structure 150 are below 2 µm.

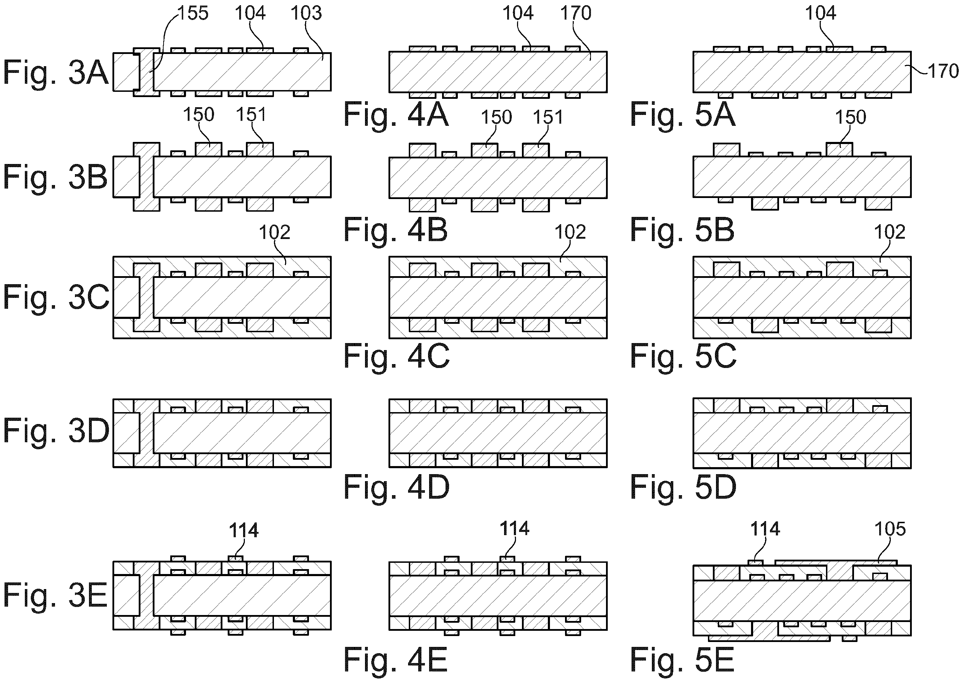

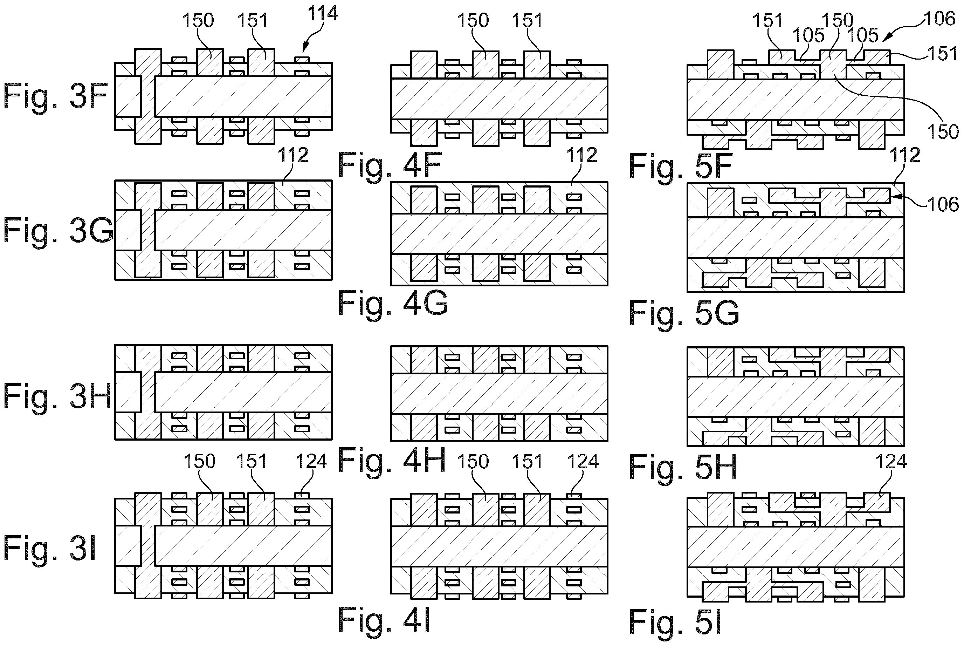

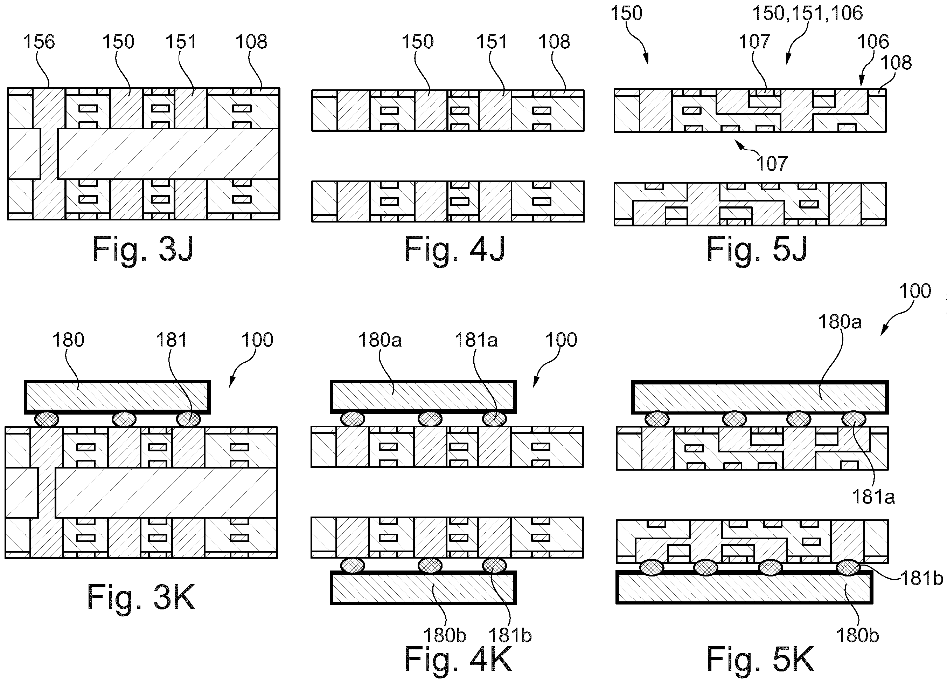

It can be further seen that a part of the upper continuously vertically extending sub-portions 132 extends (protrudes) partially into the core layer structure 103. The protruding part can be for example an embedded metal trace inside the core material. Such a structure can be a relic from the manufacture process and can be formed by a two-step process of drilling and plating. Such a structure can also be formed on purpose, e.g. to enhance stability. Furthermore, as can be seen by Figures 1A and 1B, at least two, in particular a plurality, of electrically insulating layer structures 102, 112 are in direct contact with at least two, in particular four, side wall (portions) of the vertical connection structure 150 and/or the further vertical connection structure 151.Figure 1B shows two component carriers 100 according to a further exemplary embodiment of the invention. Both component carriers 100 have been manufactured on a temporary carrier (see Figures 4 and 5), in particular on the two opposed main surfaces of the temporary carrier. Thus, in comparison to the example of Figure 1A, the layer stacks 101 are not arranged (and formed) on the opposed main surfaces of a core layer structure 103 but on the temporary carrier.

**Figures 3A to 3K** show a first method of manufacturing a component carrier 100, which includes a core layer structure 103, according to an exemplary embodiment of the invention.

Figure 3A: there is provided the core layer structure 103 (e.g. a fully cured (reinforced) resin or inorganic structure) with a vertical through-connection 155 (a filled through via). On the upper main surface and the lower main surface of the core layer structure 103, there is arranged respectively an electrically conductive layer structure 104, for example formed by patterning a continuous electrically conductive layer. It can be seen that some of the electrically conductive layer structures 104 comprise a larger width (in the horizontal direction) than others. The electrically conductive layer structure can be provided by (copper) plating.

Figure 3B: the above-mentioned electrically conductive layer structures 104 with a larger width are enlarged in the vertical direction by providing further electrically conductive material on top, e.g. by plating. Plating can be done according to established procedures, for example including providing a mask, development of the mask, plating, stripping of the mask etc. Thereby, the vertical connections structures 150 and the further vertical connection structures 151 are formed.

Figure 3C: the electrically conductive layer structures 104 at the upper and lower main surface of the core layer structure 103 are fully embedded (e.g. by lamination) in an electrically insulating material 102, e.g. an organic material, preferably glass reinforced, such as ABF (organic resins + glass spheres) as well as prepreg (organic resins + glass fabrics) as well as pure resin systems (organic resins only) or photoimageable dielectric material.

Figure 3D: a part of the electrically insulating material 102 is removed (e.g. by grinding or etching (e.g. by dry etching, in particular plasma etching) to thereby expose the upper surfaces of the electrically conductive layer structures 104 that are formed as the vertical connection structures 150 and the further vertical connection structures 151. The roughness of the vertical connection structures 150 and the further vertical connection structures 151 can be increased in this process. This measure can ensure a higher level of connection to the plating on top - as there is more surface to be connected.

Figure 3E: a second electrically conductive layer structure 114 is arranged on the electrically insulating material/layer structure 102, so that a portion of the first electrically conductive layer structure 104 (in the form of metal traces) is covered in the vertical direction. Hereby, the second electrically conductive layer structure 114 is offset with respect to the vertical connection structures 150 and the further vertical connection structures 151. The second electrically conductive layer structure 114 can be formed for example by a patterned foil or by plating.

Figure 3F: the vertical connection structures 150 and the further vertical connection structures 151 are further enlarged in the vertical direction by further electrically conductive material, e.g. by plating, so that they are higher in the vertical direction z than the second electrically conductive layer structures 114.

Figure 3G: the second electrically conductive layer structures 114 and the enlarged vertical connection structures 150 and the further vertical connection structures 151 at the upper and lower main surface of the core layer structure 103 are fully embedded (encapsulated) or molded in a second electrically insulating material 112.

Figure 3H: a part of the second electrically insulating material 112 is removed (e.g. by grinding or etching (see above)) to thereby expose only the upper surfaces of the vertical connection structures 150 and the further vertical connection structures 151.

Figure 3I: a third electrically conductive layer structure 124 is arranged on the second electrically insulating material/layer structure 112, so that a portion of the second electrically conductive layer structure 114 (in the form of metal traces) is covered in the vertical direction. In this step, also the vertical connection structures 150 and the further vertical connection structures 151 are enlarged to the same height as the metal traces (by plating). Usually, every plating sequence (also within one plating step if pulse plating is applied) one can see a kind of layer structure. Thus, the enlargement by plating can be reflected in the final product by such plating layer structures.

Figure 3J: an outer layer 108 (e.g. a solder resist) is arranged between the vertical connection structures 150, the further vertical connection structures 151, and the metal traces of the third electrically conductive layer structure 124, but so that the surfaces of said structures 124, 150, 151 are still exposed.

Figure 3K: an electronic component 180 (e.g. a semiconductor element) is mounted on top of the upper main surface of the final component carrier 100. An electric connection (here solder-balls) 181 is provided between the free (exposed) ends 156 of each of the vertical connection structures 150, 151 and the electronic component 180, respectively, so that an electric connection between the layer stack 101 and the electronic component 180 is established.

**Figures 4A to 4K** show a second method of manufacturing a component carrier 100 according to an exemplary embodiment of the invention.

Figure 4A to 4I: these steps are comparable to those described for Figures 3A to 3K, with the difference being that a temporary carrier 170 is used instead of a core layer structure 103 as a support during the layer build-up. While in the example of Figure 3 layer stacks are build-up directly above and below the core layer structure 103; in the example of Figure 4, the layer stacks are arranged only temporarily on the temporary carrier 170.

Figure 4J: the temporary carrier 170 is removed and two separate component carriers 100 are provided (see also Figure 1B). Since there is no core layer structure 103, the vertical connection structures 150, 151 are through-connections that electrically connect the upper main surface to the lower main surface and continuously extend through the complete respective stack 101 (in the vertical direction). Further possible process steps can include e.g. providing a surface finish (see specification above).

Figure 4K: like in the example of Figure 3K, an electronic component 180 is mounted on the final component carrier 100 (in the present example there are two final component carriers 100) and is electrically connected to the vertical connection structures 150, 151. At the lower main surfaces of the component carriers 100, there remain free (exposed) ends 156 of the vertical connection structures 150, 151.

**Figures 5A to 5K** show a third method of manufacturing a component carrier 100 according to an exemplary embodiment of the invention.

Figures 5A to 5D are comparable to the examples described for Figures 4A to 4D, respectively. However, the difference being that the vertical connection structures 150, 151 at the upper main surface of the temporary carrier 170 and those at the lower main surface of the temporary carrier 170 are not arranged one above the other in the vertical direction (z) but are instead offset in the vertical direction with respect to each other. The same holds also true for the metal traces of the electrically conductive layer structures 104.

Figure 5E: a second electrically conductive layer structure 114 is formed on top of the electrically insulating material 102. Hereby, said second electrically conductive layer structure 114 does not only comprise the above described metal traces but also a significantly longer (in the horizontal direction) metal trace, here termed further element 105. Said further element 105 is formed on and electrically connected to the free end 156 of the vertical connection structure 150 (on the upper and the lower main surface of the temporary carrier 170, respectively).

Figure 5F: the vertical connection structures 150 are further build-up by electrically conductive material (e.g. by plating). With respect to the further element 105, at the extremities (in the horizontal direction) of the further element 105, the electrically conductive material is provided so that two further vertical connection structures 151 are formed. In other words, there is formed a bifurcated electrically conductive network 106 with the original vertical connection structure 150 in the middle, and two further vertical connection structures 151 to the left and right side (in the horizontal direction) of the vertical connection structure 150. Said two further vertical connection structures 151 are connected to the vertical connection structure 150 in a rectangular manner, i.e. the further element 105 horizontal metal trace is arranged in an angle of 90° with respect to the vertical connection structure 150, while the two further vertical connection structures 151 are respectively connected to the further element 105 metal trace in a further angle of 90° (thereby forming a trident shape).

The bifurcated structure is bifurcated along one of the axis, but it can for example be also in the orthogonal direction with other two connections in a form of a cross or even a star with six connections etc. The left side further element 105 and the right side further element 105 may have the same thickness or a different thickness. Further element 105 can also bear a different thickness of when is part of a Power Distribution Network (PDN), e.g. where a thicker copper is required to transport higher level of currents.

Figure 5G: the enlarged vertical connection structures 150, 151 and the network structure 106 are fully embedded or molded in a second electrically insulating material 112, e.g. a prepreg.

Figure 5H: a part of the second a part of the second electrically insulating material 112 is removed (e.g. by grinding or etching) to thereby expose only the upper surfaces of the vertical connection structures 150 and the further vertical connection structures 151 (including the network structure 106).

Figure 5I: a third electrically conductive layer structure 124 is arranged on the second electrically insulating material/layer structure 112, so that a portion of the second electrically conductive layer structure 114 (in the form of metal traces) is covered in the vertical direction. In this step, also the vertical connection structures 150 and the further vertical connection structures 151 are enlarged to the same vertical height as the metal traces of the third electrically conductive layer structure 124.

Figure 5J: the temporary carrier 170 is removed, so that two final component carriers 100 can be provided. Before (or after) separation, an outer layer 108 (e.g. solder resist) is formed on the outer main surface. In particular, three structures can be identified in the final component carriers 100:
i) the vertical connection structures 150 continuously extending through the whole layer stack vertically.
ii) the bifurcated network structure 106 in form of a trident, with vertical connection structure 150 in the middle/center, the further vertical connection structures 151 to the left and right side, and the further element 105 as a horizontal connection metal trace.
iii) further metal structures (traces) 107 of the electrically conductive layer structure 104 and/or the third electrically conductive layer structure 124, wherein a portion of said metal structures 107 is located below the further element 105 (of the network structure 106) in the vertical direction. Another portion of the metal structures 107 is located between the vertical connection structure 150 and the further vertical connection structure 151 of the network structure 106. At least two sides of these smaller electrically conductive structures 107 between the vertical connection structures 150, 151 face sides of the vertical connection structure 150 and/or the bifurcated electrically conductive network structure 106.

Figure 5K: like in the examples of Figures 3K and 4K, an electronic component 180a,b is mounted on the final component carrier 100 (in the present example there are two final component carriers 100) and electrically connected 181a,b to the vertical connection structures 150, 151. At the lower main surfaces of the component carriers 100, there remain free (exposed) ends 156 of the vertical connection structures 150, 151. In this example, due to the network structure 106, a complex (yet design-flexible) electrical connection (e.g. circuit/power network) is enabled. It can be further seen that the distance (bump pitch) between the electric connections (solder bumps) 181 of the left side of the electronic component 180 is larger than at the right side of the electronic component 180.

### Reference signs

- 100: Component carrier
- 101: Stack
- 102: Electrically insulating layer structure(s)
- 103: Core layer structure
- 104: Electrically conductive layer structure
- 105: Further element, horizontal trace
- 106: Bifurcated electrically conductive network
- 108: Outer layer, e.g. surface finish, solder resist
- 112: Electrically insulating layer structure (second layer)
- 114: Electrically conductive layer structure (second layer)
- 124: Electrically conductive layer structure (third layer)
- 131: First sub-portion
- 132: Second sub-portion
- 133: Interface
- 134: Horizontal trace
- 150: Vertical connection structure
- 151: Further vertical connection structure
- 155: Vertical through-connection
- 156: Free end
- 170: Temporary carrier
- 180: Electronic component
- 181: Electrical connection, bump

## Claims

1. A component carrier (100), comprising:
a stack (101) comprising at least one electrically conductive layer structure (104) and a plurality of electrically insulating layer structures (102, 112);
wherein the at least one electrically conductive layer structure (104) comprises a vertical connection structure (150) continuously extending vertically through at least two of the plurality of electrically insulating layer structures (102, 112).

2. The component carrier (100) according to claim 1,
wherein the at least one electrically conductive layer structure (104) comprises at least one further vertical connection structure (151) continuously extending vertically through at least two of said plurality of electrically conductive layer structures (102, 112).

3. The component carrier (100) according to claim 2,
wherein the vertical connection structure (150) and the further vertical connection structure (151) are electrically connected with each other,
in particular by the electrically conductive layer structure (104).

4. The component carrier (100) according to claim 3,
wherein the vertical connection structure (150) and the further vertical connection structure (151) comprise a different width.

5. The component carrier (100) according to any one of claims 2 to 4, wherein the vertical connection structure (150) and the further vertical connection structure (151) are offset one to each other along the stack thickness direction (z).

6. The component carrier (100) according to claim 5,
wherein the vertical connection structure (150), the further vertical connection structure (151) and at least one further element (105) of the at least one electrically conductive layer structure (104) form a bifurcated electrically conductive network structure (106),
in particular wherein the bifurcated electrically conductive network structure (106) comprises at least two extremities on one side and one extremity at another, opposed, side;
more in particular wherein the bifurcated electrically conductive network structure (106) comprises at least three extremities on one side and one extremity at another, opposed, side;
and/or
wherein at least two of the vertical connection structure (150), the further vertical connection structure (151), and the at least one further element (105) are connected, in particular within the bifurcated electrically conductive network structure (106), by one or more rectangular forms.

7. The component carrier (100) according to any one of the preceding claims, wherein the vertical connection structure (150) is formed on or above a core layer structure (103),
in particular wherein the vertical connection structure (150) is electrically connected with a vertical through-connection (155), in particular having substantially continuous vertical sidewalls, extending vertically through the core layer structure (103);
or
wherein the vertical connection structure (150) is formed in a coreless stack.

8. The component carrier (100) according to any one of the preceding claims, wherein a free end (156) of the vertical connection structure (150) is exposed with respect to one of the stack (101) surfaces.

9. The component carrier (100) according to any one of the preceding claims, wherein the vertical connection structure (150) is connected to a horizontal trace (134) of the at least one electrically conductive layer structure (104),
in particular wherein said trace (134) is arranged at a vertical level (z) in between vertical levels (z) of opposing vertical ends of said vertical connection structure (150) and/or said further vertical connection structure (151).

10. The component carrier (100) according to any one of the preceding claims,
wherein the vertical connection structure (150) is composed of at least two stacked sub-portions (131, 132) with an interface (133) in between,
in particular wherein said interface (133), in particular a surface, is at the same vertical level (z) as an interface between two adjacent electrically insulating layer structures (102).

11. The component carrier (100) according to claim 10,
wherein a lateral misalignment between said continuously vertically extending sub-portions (131, 132) is so that the center lines of each sub-portion (131, 132) are positioned inside of a virtual circle of a diameter in a range from 2 µm to 10 µm, in particular not more than 5 µm, and/or
wherein lateral steps between the adjacent sub-portions (131, 132) of the continuously vertically extending connection structure (150) are below 2 µm.

12. The component carrier (100) according to any one of the preceding claims, wherein the vertical connection structure (150) is made of a homogeneous material, in particular plated metal, more particular plated copper.

13. A method of manufacturing a component carrier (100), wherein the method comprises:
providing a stack (101) comprising at least one electrically conductive layer structure (104) and a plurality of electrically insulating layer structures (102, 112); and
forming the at least one electrically conductive layer structure (104) with a vertical connection structure (150) continuously extending vertically through at least two of said plurality of electrically insulating layer structures (102, 112).

14. The method according to claim 13, further comprising:
wherein forming the vertical connection structure (150) further comprises:
plating the vertical connection structure (150), in particular on a core layer structure (103) or a temporary carrier (170).

15. The method according to claim 13 or 14, further comprising:
embedding, in particular by laminating, the at least one electrically conductive layer structure (104), in particular with the vertical connection structure (150), at least partially in at least one of the electrically insulating layer structures (102, 112),
in particular wherein embedding is done after forming the vertical connection structure (150) by plating.
